(19) Europäisches Patentamt

European Patent Office

Office européen des brevets

(11) Veröffentlichungsnummer: **0 180 761**
**B1**

(12) **EUROPÄISCHE PATENTSCHRIFT**

(45) Veröffentlichungstag der Patentschrift: **14.03.90**

(21) Anmeldenummer: **85112343.0**

(22) Anmeldetag: **28.09.85**

(51) Int. Cl.⁵: **H 03 K 4/72,** H 04 N 3/227,
H 03 K 4/50

(54) **Schaltungsanordnung für die Vertikalablenkung von Elektronenstrahlen in Fernsehbildröhren.**

(30) Priorität: **02.11.84 DE 3440024**

(43) Veröffentlichungstag der Anmeldung:
**14.05.86 Patentblatt 86/20**

(45) Bekanntmachung des Hinweises auf die
Patenterteilung:
**14.03.90 Patentblatt 90/11**

(84) Benannte Vertragsstaaten:
**DE FR GB NL**

(56) Entgegenhaltungen:
**DE-C-2 141 297**
**FR-A-2 305 065**
**US-A-4 225 825**

**IEEE TRANSACTIONS ON CONSUMER
ELECTRONICS, Band CE-24, Nr. 3, August 1978,
Seiten 185-189, IEEE, New York, US; Y.
YOSHIMI et al.: "Second generation IC's for
color TV receivers (Part II)"**

(73) Patentinhaber: **Deutsche Thomson-Brandt
GmbH
Hermann-Schwer-Strasse 3 Postfach 1307
D-7730 Villingen-Schwenningen (DE)**

(72) Erfinder: **Berland, Pierre-Axel
Am Kopsbühl 54
D-7730 Villingen-Schwenningen (DE)**
Erfinder: **Rufray, Jean-Claude
Hans-Thoma-Strasse 6
D-7734 Brigachtal (DE)**

## Beschreibung

Die Erfindung geht aus von einer Schaltungsanordnung für die Vertikalablenkung von Elektronenstrahlen in Fernsehbildröhren mittels eines durch eine Konstantstromquelle aufladbaren Kondensators zur Erzeugung eines Steuersignals für die Vertikalablenk-Endstufe, wobei der Kondensator periodisch nach einer vertikalen Ablenkperiode über einen elektronischen Schalter entladen wird und das Steuersignal für den elektronischen Schalter von einer die Zeilen des Fernsehbildes zählenden Zählschaltung abgeleitet wird, die eine erste Komparatorschaltung aktiviert, welche die am Kondensator liegende Ist-Spannung mit einer Referenzspannung vergleicht. Eine derartige Schaltung ist bekannt durch die intergrierte Schaltung TEA 2026 seit März 1983.

Die erzeugte Sägezahnspannung besitzt eine Gleichspannungskomponente, der sie überlagert ist. Eine Veränderung dieser Gleichspannung bewirkt eine vertikale Bildverschiebung. Die Amplitude der Sägezahnspannung und damit die Bildhöhe kann auf verschiedene Weise verändert werden, sei es durch Verändern der Verstärkung des Stromgenerators oder durch Änderung der Gegenkopplung des Endverstärkers. Die genannte Schaltung besitzt jedoch noch große Nachteile. So ändert sich z.B. das Bildformat bei Änderung des Kondensators durch Alterung, Temperatur usw. Auch die Bildhöhe und die Bildlage werden dabei verschoben. Die Amplitudeneinstellung und Bildlageeinstellung sind nicht unabhängig voneinander. Bei einer Änderung der Bildhöhe, d.h. der Amplitude des Ablenkstromes, erfolgt diese unsymmetrisch zur Bildmitte. Nach der Amplitudeneinstellung ist eine Bildlagekorrektur erforderlich.

In der FR—A—2 305 065 wird eine Schaltungsanordnung beschrieben, die zwei Konstantstromquellen (hier 18 und 31) besitzt, von denen die eine (18) zur Aufladung des Kondensators (2) immer eingeschaltet ist. Bei einer Abweichung der Amplitude der erzeugten Sägezahnspannung wird die zweite Konstantstromquelle (31) zugeschaltet. Dieser Schaltung liegt die Aufgabe zugrunde, die Amplitude der Spannung konstant zu halten. Dies geschieht, indem der Mittelwert der Sägezahnspannung mit einem festen Referenzwert verglichen und auf einen festern Wert geregelts wird.

In der US—A—4 225 825 ist eine Schaltung gezeigt, die einen Generator zur Erzeugung einer Sägezahnspannung besitzt, deren Amplitude durch eine logische Schaltung in engen Grenzen konstant gehalten wird. Es geht bei dieser Anordnung nicht darum, einen bestimmten Wert der Ablenkspannung konstant zu halten.

Der Erfindung liegt die Aufgabe zugrunde, die Justierung des Bildes bei temperaturbedingten oder auch alterungsbedingten Änderungen des Ladekondensators und die daraus resultierende Formatänderung des Rasters, welche eine Amplitudennachstellung erforderlich macht, zu vereinfachen. Diese Aufgabe wird durch die im Patentanspruch angegebene Erfindung gelöst. Die Erfindung bringt den Vorteil, daß die Bildlage automatisch geregelt wird und daß Amplitudenänderungen symmetrisch zur Bildmitte erfolgen. Die Amplitudeneinstellung und Bildlageverschiebung können ohne Stellglieder vorgenommen werden und die Schaltung eignet sich insbesondere in Verbindung mit Mikroprozessorsteuerung, bei welcher die erforderlichen Einstellungen über Digital-Analog-Wandler erfolgen.

Nachstehend soll die Erfindung an einem Ausführungsbeispiel mit Hilfe der Zeichnung erläutert werden.

Figur 1 zeigt eine Schaltung nach dem Stand der Technik,

Figur 2 zeigt die Schaltung mit den Maßnahmen nach der Erfindung.

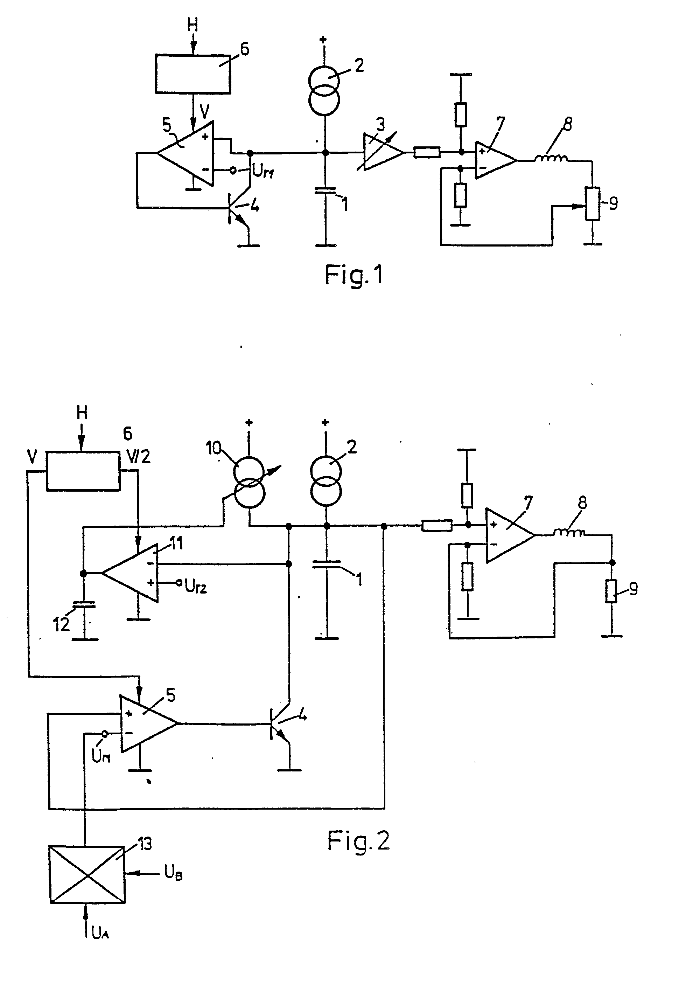

In Figur 1 sei zunächst die Schaltung beschrieben, wie sie in der integrierten Schaltung TEA 2026 verwirklicht ist.

Ein Kondensator 1 wird von einer Konstantstromquelle 2 aufgeladen. An dem Kondensator 1 entsteht eine sägezahnförmige Steuerspannung für einen in seiner Verstärkung steuerbaren Verstärker 3. Die am Ende der Vertikalablenkung erfolgende Entladung des Kondensators 1 geschieht mit Hilfe eines elektronischen Schalters 4, der von einer Komparatorschaltung 5 angesteuert wird. Die Komparatorschaltung 5 wird mit Hilfe einer Zählschaltung 6 aktiv geschaltet. Die Zählschaltung 6 zählt zeilenfrequente Impulse H und erzeugt nach einer einem Hilbbild entsprechenden Zeilenzahl ein Steuerimpuls V. Während dieses Impulses entlädt sich der Kondensator 1 auf die durch die an einem Komparatoreingang vorgegebene Referenzspannung Ur1, wonach der Kondensator 1 wieder aufgeladen wird. Die am Ausgang der Verstärkerstufe 3 entstehende Spannung wird auf den Eingang einer Endstufe 7 gegeben, die den für die Vertikalablenkwicklung 8 notwendigen Ablenkstrom liefert. In Serie zur Ablenkwicklung 8 ist ein Widerstand 9 geschaltet, an welchem eine Gegenkopplungsspannung für die Endstufe 7 abgreifbar ist. Bei Veränderung der Referenzspannung Ur1 ändert sich die Bildlage, da die Amplitude durch die Konstantstromquelle konstant gehalten wird.

In Figur 2 ist die abgewandelte Schaltung dargestellt, in welcher die in Figur 1 erläuterten Elemente mit den gleichen Bezugsziffern versehen sind.

Parallel zur ersten Konstantstromquelle 2 ist eine zweite reglebare Stromquelle 10 geschaltet. Diese Stromquelle ist darart steuerbar, daß sie den Ladestrom für den Kondensator 1 so ergänzt, daß sich die Spannung am Kondensator bezüglich eines Ablenkzeitpunktes auf einen Festwert einstellt. Dieser Zeitpunkt ist auf die Mitte der Vertikalablenkung bezogen. Dazu wird mit Hilfe einer weiteren Komparatorschaltung 11 die Ist-Spannung am Kondensator 1 mit einer festen Referenzspannung Ur2 verglichen. Diese Referenzspannung entspricht einer Spannung, die am Kondensator 1 anliegen muß, um den Elektronenstrahl vertikal bis zur Mitte abzulenken. Der Vergleich findet dabei während einer Zeile in Bildmitte statt. Dies geschieht mit Hilfe der Zählschaltung 6, die nach einer entsprechenden Zeilenzahl durch den Impuls V/2 die Komparatorschaltung 11 aktiviert. Weicht die am Kondensator 1 liegende Spannung von dem zu diesem gegebenen Zeitraum vorgegebenen Sollwert ab, entsteht ein Steuerimpuls am Ausgang der Komparatorschaltung 11. Dieser Wert wird mittels des Kondensator 12 für eine Bildperiode konstant gehalten.

Durch Verändern der Spannung Ur1 kann die Amplitude der Ablenkung verändert werden. Die Amplitude wird z.B. dadurch vergrößert, daß an den Komparator 5 angelegte Referenzspannung verkleinert wird, so daß die Entladung des Kondensators 1 auf einen kleineren Spannungswert zu einem späteren Zeitpunkt erfolgt. Durch die zweite Regelschleife, die die Mittenspannung der Ablenkung konstant hält, wird die Amplitude symmetrisch vergrößert.

Bei Schwankungen der Betriebsspannung z.B. für die Vertikalablenkung infolge von Strahlstromänderungen ändert sich die Ablenkamplitude und damit das Bildformat. Es ist deshalb notwendig die Referenzspannung Ur1 zu ändern, um das Format konstant zu halten. Hierzu wird einer Multiplizierschaltung 13 eine der Betriebsspannung $U_B$ maßgebliche Größe sowie die Amplitudeneinstellgröße $U_A$ zugeführt. Aus diesen beiden Größen wird die Referenzspannung Ur1 abgeleitet. Erniedrigt sich z.B. infolge einer Strahlstromerhöhung die Größe $U_B$ wird die Multiplizierschaltung 13 automatisch auch die Referenzspannung Ur1 erniedrigt—wodurch die Ablenk-Amplitude ansteigt.

**Patentansprüche**

1. Schaltungsanordnung für die Vertikalablen-kung von Elektronenstrahlen in Fernsehbildröh-ren mittels eines durch eine Konstantstromquelle (2) aufladbaren Kondensators (1) zur Erzeugung eines Steuersignals für die Vertikal-Ablenkendstufe, wobei der Kondensator periodisch nach einer vertikalen Ablenkperiode über einen elektronischen Schalter (4) entladen wird und das Steuersignal für den elektronischen Schalter von einer die Zeilen des Fernsehbildes zählenden Zählschaltung (6) abgeleitet wird, die eine erste Komparatorschaltung (5) aktiviert, welche die am Kondensator liegende Ist-Spannung mit einer Refe-renzspannung vergleicht, dadurch gekennzeich-net, daß parallel zur Konstantstromquelle (2) eine weitere regelbare Stromquelle (18) geschaltet ist, welche den Ladestrom des Kondensators (1) derart steuert, daß die der Bildmitte entsprechende Spannung des Kondensators auf einen konstanten Wert gehalten wird, indem an den Kondensator (1) eine zweite Komparatorschaltung (11) geschaltet ist, die die Spannung am Kondensator (1) mit einem Sollwert (Ur2) vergleicht, welche bei Abweichung von diesem Sollwert eine Steuerspannung für die regelbare Stromquelle (10) erzeugt und daß die zweite Komparatorschaltung (11) von der Zählschaltung (6) während einer der Mitte des Bildhinlaufs entsprechenden Zeit aktiv geschaltet ist, wobei der Betrag der an den zwei-ten Komparator (11) gelegten Vergleichsspan-nung (Ur2) der am Kondensator (1) anliegenden Sollspannung für die Hälfte des vertikalen Hinlaufs des Elektronenstrahls entspricht.

2. Schaltungsanordnung nach Anspruch 1, dadurch gekennzeichnet, daß an den Ausgang des zweiten Komparators (11) ein Kondensator (12) geschaltet ist, der den von dem zweiten Komparator (11) erzeugten Spannungswert für die Dauer einer vertikalen Ablenkperiode speichert.

3. Schaltungsanordnung nach Anspruch 1, dadurch gekennzeichnet, daß die der ersten Kom-paratorschaltung (5) zugeführte Referenzspan-nung (Ur1) zur Amplitudeneinstellung der Ablenkung dient.

4. Schaltungsanordnung nach Anspruch 1, dadurch gekennzeichnet, daß die der zweiten Komparatorschaltung (11) zugeführte Referenzspannung (Ur2) zur Bildlageverschiebung dieht.

5. Schaltungsanordnung nach Anspruch 6, dadurch gekennzeichnet, daß an den Referenz-spannungseingang (Ur1) der ersten Komparator-schaltung (5) eine Multiplizierschaltung (13) angeschlossen ist, welche aus ihr zugeführten Steuer-größen ($U_A$, $U_B$) die Referenzspannung (Ur1) derart nachstellt, daß die Ablenkamplitude und damit das Bildformat konstant bleibt.

**Revendications**

1. Circuit pour la déflexion verticale d'un faisceau électronique dans les tubes image de télévision au moyen d'un condensateur (1) rechargeable par une source de courant constant (2) en vue de générer un signal de commande pour l'étage de déflexion verticale, le condensateur étant déchargé périodiquement après une période de déflexion verticale par un interrupteur électronique (4) et le signal de commande destiné à l'interrupteur électronique étant dérivé d'un circuit de comptage (6) comptant les lignes de l'image de télévision et activant un premier circuit comparateur (5) qui compare la tension effective appliquée au condensateur à une tension de référence, caractérisé en ce qu'une autre source de courant réglable (10) est montée en parallèle à la source de courant constant (2) et commande le courant de charge du condensateur (1) de manière que la tension du condensateur correspondant au centre de l'image est maintenue à une valeur constante par un deuxième circuit comparateur (11) connecté au condensateur (1), qui compare la tension appliquée au condensateur (1) à une valeur de consigne (Ur2) et génère une tension de commande pour la source de courant réglable (10) lorsqu'elle s'écarte de cette valeur de consigne, et que le circuit de comptage (6) met à l'état actif le deuxième circuit comparateur (11) pendant une durée de balayage aller de l'image correspondant au centre, la valeur de la tension (Ur2) appliquée au deuxième circuit comparateur (11) correspondant pour la moitié du balayage aller vertical du faisceau électronique à la tension de consigne appliquée au condensateur 1.

2. Circuit selon la revendication 1, caractérisé en ce qu'un condensateur (12) qui stocke la tension générée par le deuxième comparateur (11) pour la durée d'une période de déflexion verticale, est reliée à la sortie du deuxième comparateur (11).

3. Circuit selon la revendication 1, caractérisé en ce que la tension de référence (Ur1) envoyée au premier circuit comparateur (5) sert au réglage d'amplitude de la déflexion.

4. Circuit selon la revendication 1, caractérisé en ce que la tension de référence (Ur2) envoyée au deuxième circuit comparateur (11) sert au décalage de la position d'image.

5. Circuit selon la revendication 4, caractérisé en ce que l'entrée de la tension de référence (Ur1) du premier circuit comparateur (5) est reliée à un circuit multiplicateur (13) qui réajuste la tension de référence (Ur1) à partir des grandeurs de commande (U, U) qu'elle reçoit, de telle sorte que l'amplitude de déflexion et par conséquent, le format de l'image demeurent constants.

**Claims**

1. Circuit layout for the vertical deflection of electron beams in television picture tubes by means of a capacitor (1) chargeable by a constant current source (2) for the generation of a control signal for the vertical deflection end stage, in which the capacitor is discharged periodically after a vertical deflection period by means of an electronic switch (4) and the control signal for the electronic switch is derived from a counting circuit (6) counting the lines of the television picture, said counting circuit (6) activating a first comparator circuit (5) which compares the actual voltage applied to the capacitor with a reference voltage, characterised in that parallel to the constant current source (2) is connected a further controllable current source (10) which controls the charging current of the capacitor (1) in such a way that the voltage of the capacitor corresponding to the centre of the picture is kept to a constant value by there being connected to the capacitor (1) a second comparator circuit (11) which compares the voltage on the capacitor (1) with a desired value (Ur2), which on deviation from this desired value generates a control voltage for the controllable current source (10), and that the second comparator circuit (11) is activated by the counting circuit (6) during a time corresponding to the centre of the picture sweep, the level of the comparison voltage (Ur2) applied to the second comparator (11) corresponding to the desired voltage applied to the capacitor (1) for half the vertical sweep of the electronic beam.

2. Circuit layout according to claim 1, characterized in that to the output of the second comparator (11) there is connected a capacitor (12) which stores for the duration of a vertical deflection period the voltage value generated by the second comparator (11).

3. Circuit layout according to claim 1, characterized in that the reference voltage (Ur1) supplied to the first comparator circuit (5) serves for the amplitude setting of the deflection.

4. Circuit layout according to claim 1, characterized in that the reference voltage (Ur2) supplied to the second comparator circuit (11) serves for the picture positioning control.

5. Circuit layout according to claim 6, characterized in that there is connected to the reference voltage input (Ur1) of the first comparator circuit (5) a multiplier (13), which out of control values (U$_A$, U$_B$) fed to it adjusts the reference voltage (Ur1) in such a way that the deflection amplitude and hence the picture ratio remains constant.

Fig.1

Fig.2